# EUROPÄISCHE PATENTSCHRIFT

(11) **EP 0 802 444 B1**
(45) Veröffentlichungstag und Bekanntmachung des Hinweises auf die Patenterteilung: **13.06.2001**
(21) Anmeldenummer: 97101081.4
(22) Anmeldetag: 24.01.1997
(51) Int. Cl.: G02F 1/13

(54) **Aufnahmevorrichtung für eine Flüssigkristallanzeigevorrichtung**
Holder for a liquid crystal display device
Dispositif de fixation d'un afficheur à cristal liquide

(30) Priorität: 19.04.1996 DE 19615458
(43) Veröffentlichungstag der Anmeldung: 22.10.1997
(73) Patentinhaber: Mannesmann VDO AG, 60326 Frankfurt (DE)
(72) Erfinder: Urlaub, Günter, 64850 Schaafheim-Schlierbach (DE); Wesner, Gerhard, 65843 Sulzbach (DE); Friepes, Gerhard, 61231 Bad Nauheim (DE); Kneer, Bernward, 63791 Karlstein (DE)
(74) Vertreter: Klein, Thomas, Dipl.-Ing. (FH)

(56) Entgegenhaltungen:
- DE-A- 3 408 176
- US-A- 5 270 847
- PATENT ABSTRACTS OF JAPAN vol. 095, no. 008, 29.September 1995 & JP 07 134284 A (SHARP CORP), 23.Mai 1995,

## Beschreibung

Die Erfindung betrifft eine Aufnahmevorrichtung mit einem Einsatz und einem Gehäuse zur Aufnahme eines Kontaktflächen aufweisenden LCD-Bildschirms und mit Federelementen, welche zum Vorspannen von Leitelementen gegen die Kontaktflächen und des LCD-Bildschirms gegen das Gehäuse ausgebildet sind.

Eine solche Aufnahmevorrichtung wird häufig eingesetzt, um LCD-Bildschirme aufzunehmen und zu kontaktieren. Dabei sind in dem Einsatz der Aufnahmevorrichtung Nuten zur Aufnahme der Federelemente eingearbeitet. Diese Federelemente sind beispielsweise als Gummipuffer ausgebildet und spannen die Leitelemente gegen die Kontaktflächen und den LCD-Bildschirm gegen das Gehäuse vor. Hierdurch ist der LCD-Bildschirm gleichzeitig in der Aufnahmevorrichtung befestigt und mit den Leitelementen kontaktiert. Wenn in dem Einsatz ein Lichtkasten zur Durchleuchtung des LCD-Bildschirms angeordnet ist, werden die Leitelemente zur Vereinfachung der Montage bis zu der Rückseite der Aufnahmevorrichtung geführt. Dort werden zur Kontaktierung mit Kontaktflächen einer Anschlußbuchse ebenfalls Gummipuffer angeordnet. Solche Gummipuffer tragen zu einer unnötigen Erhöhung des Herstellungs- und Montageaufwandes der Aufnahmevorrichtung bei.

Beispiele für soche Vorrichtungen sind aus DE 34 08 176 A oder US 5 270 847 A bekannt.

Der Erfindung liegt das Problem zugrunde, eine Aufnahmevorrichtung der eingangs genannten Art so zu gestalten, daß sie möglichst kostengünstig herzustellen und zu montieren ist.

Dieses Problem wird erfindungsgemäß durch die Merkmale das Anspruchs 1 gelöst. Durch diese Gestaltung werden die Federelemente nicht mehr wie bei der bekannten Aufnahmevorrichtung separat in den Einsatz eingesetzt, sonders sie sind bereits bei deren Herstellung einteilig an ihr vorgesehen. Hierdurch wird der LCD-Bildschirm bei einem Zusammenbau der Aufnahmevorrichtung automatisch zwischen dem Einsatz und dem Gehäuse eingespannt, ohne daß es einer vorherigen Montage von Federelementen in den Einsatz bedarf. Die Kunststofffedern können am Einsatz oder am Gehäuse angespritzt sein. Wenn die Kunststoffedern an dem Gehäuse angespritzt sind, wird der LCD-Bildschirm gegen den Einsatz vorgespannt. Die Herstellung des Gehäuses oder des Einsatzes aus Kunststoffspritzguß ermöglicht besonders in einer Serienherstellung ein kostengünstiges Anspritzen der Kunststoffedern.

Die Kunststoffedern können beispielsweise von dem Gehäuse oder dem Einsatz abstehende Federzungen sein. Sie verfügen jedoch über einen besonders großen Federweg, wenn die Kunststoffedern gemäß einer vorteilhaften Weiterbildung der Erfindung eine S-förmige Gestalt aufweisen. Der große Federweg erleichtert die Montage des LCD-Bildschirms in der Aufnahmevorrichtung und ermöglicht es, unterschiedlich dicke LCD-Bildschirme in der Aufnahmevorrichtung einzusetzen.

Der LCD-Bildschirm wird gleichmäßig gegen den Einsatz oder das Gehäuse vorgespannt, wenn für einen seitlichen Bereich des LCD-Bildschirms mehrere Kunststoffedern vorhanden sind, welche miteinander über einen Ausgleichsbalken verbunden sind. Der Ausgleichsbalken verteilt die Federkräfte der Kunststoffedern über einen seitlichen Bereich des LCD-Bildschirms und ermöglicht zudem eine gleichmäßige Vorspannung der Leitelemente gegen die Kontaktflächen.

Die Leitelemente könnten beispielsweise einfache Kabel sein, deren Enden in Ausnehmungen der Kunststoffedern oder des Ausgleichsbalkens befestigt werden. Die Kontaktierung der Kontaktflächen des LCD-Bildschirms mit den Leitelementen gestaltet sich jedoch besonders zuverlässig, wenn die Leitelemente auf einer Heißklebefolie aufgebrachte Leiterbahnen sind. Eine solche Heißklebefolie wird zur gleichzeitigen Befestigung und Kontaktierung auf die Kontaktflächen aufgedrückt und erwärmt. Die Vorspannung der Leiterbahnen gegen die Kontaktflächen durch die Kunststoffedern dient der zusätzlichen Sicherheit der Kontaktierung.

Die Erfindung läßt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig. 1: eine Schnittdarstellung durch eine erfindungsgemäße Aufnahmevorrichtung,
- Fig.2: eine Schnittdarstellung durch die Aufnahmevorrichtung aus Fig.1 entlang der Linie I - I.

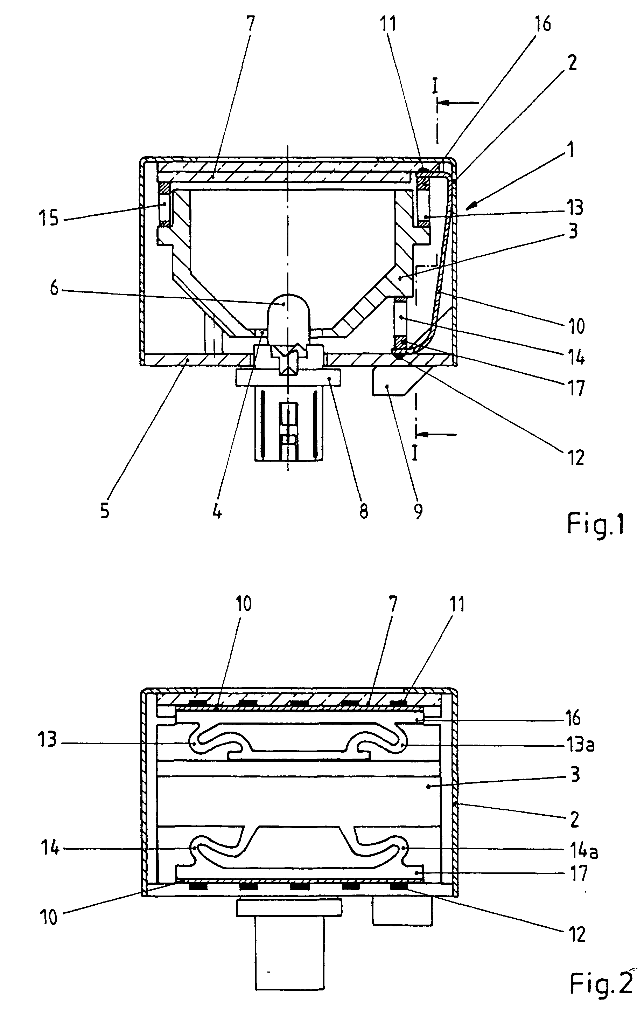

Die Figur 1 zeigt eine erfindungsgemäße Aufnahmevorrichtung 1 mit einem Gehäuse 2 und einem als Lichtkasten ausgebildeten Einsatz 3. Der Einsatz 3 hat eine Öffnung 4, durch die eine auf einer Platine 5 angeordnete Lampe 6 hineinragt. Die Lampe 6 dient damit der Durchleuchtung eines LCD-Bildschirms 7. Die Lampe 6 hat einen Sockel 8. Auf der Platine 5 ist eine Anschlußbuchse 9 angeordnet, über welche der LCD-Bildschirm 7 mit elektrischem Strom versorgt wird. Der LCD-Bildschirm 7 ist mit einer Heißklebefolie 10 mit der Platine 5 verbunden. Hierzu haben die Platine 5 und der LCD-Bildschirm 7 jeweils Kontaktflächen 11, 12. An dem Einsatz 3 angespritzte Kunststofffedern 13 - 15 spannen die Heißklebefolie 10 gegen die Kontaktflächen 11, 12 und den LCD-Bildschirm 7 gegen das Gehäuse 2 vor.

Die Gestaltung der Kunststoffedern 13, 14 ist besonders deutlich in Figur 2 zu erkennen. Die Figur 2 zeigt, daß die Heißklebefolie 10 gegen die Kontaktflächen 11 des LCD-Bildschirms 7 und gegen die Kontaktflächen 12 der Anschlußbuchse 9 mit jeweils zwei Kunststoffedern 13, 13a, 14, 14a vorgespannt ist. Die Kunststoffedern weisen jeweils eine S-förmige Gestalt auf. Die Kunststoffedern 13, 14 sind jeweils paarweise mit einem Ausgleichsbalken 16, 17 verbunden. Die Kunststoffedern 13 - 15, der Einsatz 3 und die Ausgleichsbalken 16, 17 sind als ein Bauteil aus Kunststoffspritzguß gefertigt.

## Patentansprüche

1. Aufnahmevorrichtung (1) mit einem Einsatz (3) und einem Gehäuse (2) zur Aufnahme eines Kontaktflächen (11) aufweisenden LCD-Bildschirms (7) und mit Federelementen (13, 14), welche zum Vorspannen von Leitelementen gegen die Kontaktflächen (11) und des LCD-Bildschirms (7) gegen das Gehäuse (2) ausgebildet sind, wobei die Aufnahmevorrichtung (1) zumindest teilweise aus Kunststoffspritzguß besteht, **dadurch gekennzeichnet,** daß die Federelemente (13, 14) an dem Gehäuse (2) oder dem Einsatz (3) angespritzte Kunststoffedern (13, 14) sind, daß die Leitelemente auf einer Heißklebefolie (10) aufgebrachte Leiterbahnen sind, daß die Heißklebefolie (10) den LCD-Bildschirm (7) mit einer Kontaktflächen (12) aufweisenden Platine (5) verbindet und daß die Kunststoffedern (13, 14) die Heißklebefolie (10) gegen die Kontaktflächen (11, 12) der Platine (5) und des LCD-Bildschirms (7) vorspannen.

2. Aufnahmevorrichtung nach Anspruch 1, **dadurch gekennzeichnet,** daß die Kunststoffedern (13 - 15) eine S-förmige Gestalt aufweisen.

3. Aufnahmevorrichtung nach Anspruch 1 oder 2, **dadurch gekennzeichnet,** daß für einen seitlichen Bereich des LCD-Bildschirms (7) mehrere Kunststoffedern (13, 13a, 14, 14a) vorhanden sind, welche miteinander über einen Ausgleichsbalken (16, 17) verbunden sind.

## Claims

1. Receptacle (1) having an insert (3) and a housing (2) for accommodating an LCD screen (7), which has contact surfaces (11), and having spring elements (13, 14) which are designed for prestressing conducting elements against the contact surfaces (11) and the LCD screen (7) against the housing (2), the receptacle (1) comprising, at least in part, a plastic injection moulding, characterized in that the spring elements (13, 14) are plastic springs (13, 14) which are moulded on the housing (2) or the insert (3), in that the conducting elements are conducting tracks provided on a heat-sealing foil (10), in that the heat-sealing foil (10) connects the LCD screen (7) to a printed circuit board (5) having contact surfaces (12), and in that the plastic springs (13, 14) prestress the heat-sealing foil (10) against the contact surfaces (11, 12) of the printed circuit board (5) and of the LCD screen (7).

2. Receptacle according to Claim 1, characterized in that the plastic springs (13 - 15) have an S-shaped configuration.

3. Receptacle according to Claim 1 or 2, characterized in that a plurality of plastic springs (13, 13a, 14, 14a) which are connected to one another via an equalizing bar (16, 17) are provided for a lateral region of the LCD screen (7).

## Revendications

1. Dispositif de réception (1) avec un insert (3) et un boîtier (2) pour recevoir un écran d'affichage à cristaux liquides (7) présentant des faces de contact (11) et avec des éléments à ressort (13, 14) qui sont conçus pour précontraindre des éléments conducteurs contre les faces de contact (11) et l'écran d'affichage à cristaux liquides (7) contre le boîtier (2), le dispositif de réception (1) se composant au moins partiellement d'un moulage par injection en plastique, **caractérisé en ce que** les éléments à ressort (13, 14) sont des ressorts en plastique (13, 14) moulés par injection contre le boîtier (2) ou l'insert (3), en ce que les éléments conducteurs sont des pistes conductrices appliquées sur un film thermoadhésif (10), en ce que le film de thermoadhésif (10) relie l'écran d'affichage à cristaux liquides (7) à une platine (5) présentant des faces de contact (12) et en ce que les ressorts en plastique (13, 14) réalisent la précontrainte du film thermoadhésif (10) contre les faces de contact (11, 12) de la platine (5) et de l'écran d'affichage à cristaux liquides (7).

2. Dispositif de réception selon la revendication 1, **caractérisé en ce que** les ressorts en plastique (13 - 15) présentent une configuration en forme de S.

3. Dispositif de réception selon la revendication 1 ou 2, **caractérisé en ce que** pour une zone latérale de l'écran d'affichage à cristaux liquides (7), plusieurs ressorts en plastique (13, 13a, 14, 14a) sont prévus, lesquels sont connectés les uns aux autres par le biais d'une poutre d'équilibrage (16, 17).
